# EUROPÄISCHE PATENTSCHRIFT

(11) **EP 0 292 913 B1**
(45) Veröffentlichungstag und Bekanntmachung des Hinweises auf die Patenterteilung: **03.11.1993**
(21) Anmeldenummer: 88108255.6
(22) Anmeldetag: 24.05.1988
(51) Int. Cl.: H03K 17/16, H03K 17/687

(54) **Als integrierte Schaltung ausgebildete Schaltereinrichtung**
Switch device built as an integrated circuit
Dispositif de commutation en circuit intégré

(30) Priorität: 27.05.1987 DE 3717922
(43) Veröffentlichungstag der Anmeldung: 30.11.1988
(73) Patentinhaber: SGS-THOMSON MICROELECTRONICS GMBH, 85567 Grafing (DE)
(72) Erfinder: Stockinger, Josef, Dipl.-Ing., D-8000 München 40 (DE)
(74) Vertreter: Klunker . Schmitt-Nilson . Hirsch

(56) Entgegenhaltungen:
- EP-A- 0 091 265
- US-A- 4 544 854
- E.D.N. ELECTRICAL DESIGN NEWS, Band 32, Nr. 10, 14. Mai 1987, Seiten 193-196,198,200, Newton, MA, US; G. SCHAFFER: "Low-cost circuits maintain quality of multiplexed video signals"
- ELECTRONIC ENGINEERING, Band 59, Nr. 730, Oktober 1987, Seiten 43,44,48,52, Woolwich, London, GB; G. SCHOFFER: "Monolithic CMOS Video mux/amp pushes 50MHz"
- PATENT ABSTRACTS OF JAPAN, Band 12, Nr. 403 (E-674)(3250), 26. Oktober 1988; & JP-A-63 144620 (NIPPON DENSO CO LTD) 16.06.1988
- PATENT ABSTRACTS OF JAPAN, Band 3, Nr. 13 (E-88), 7. Februar 1979, Seite 70; & JP-A-53 140553 (HITACHI SEISAKUSHO K.K.) 12.07.1978
- PATENT ABSTRACTS OF JAPAN, Band 10, Nr. 224 (E-425)(2280), 5. August 1986; & JP-A-61 60012 (FUJITSU LTD) 27.03.1986
- PATENT ABSTRACTS OF JAPAN, Band 6, Nr. 28 (E-95)(906), 19. Februar 1982; & JP-A-56 149118 (NIPPON DENSHIN DENWA KOSHA) 18.11.1981
- RUNDFUNKTECHNISCHE MITTEILUNGEN, Jahrgang 20, Heft 6, 1976, Seiten 247-253, Hamburg, DE; P. WURLL: "Ein vollelektronischer Analogschalter mit Studioqualitätsdaten in MOS-Technik für dynamische und statische Ansteuersignale"
- ELEKTRONIK INDUSTRIE, Band 6, 1984, Seiten 74,78-80; W. HEINZER: "Digitales Schalten von Analogsignalen mit dem DG308A"

## Beschreibung

Die Erfindung betrifft eine als integrierte Schaltung ausgebildete Schaltereinrichtung gemäß Obergriff des Anspruchs 1.

Eine solche Schaltereinrichtung ist aus E. D. N. ELECTRICAL DESIGN NEWS, Band 32, Nr. 10, 14.05.1987, Seiten 193 bis 196, 198, 200, bekannt.

Derartige Schaltereinrichtungen eignen sich beispielsweise für Multiplexer, insbesondere zum Einsatz bei Analog/Digital-Wandlern.

Als integrierte Schaltung ist der Multiplexer auf einem Chip ausgebildet, dessen Spannungsversorgung durch zwei Grenzpotentiale gekennzeichnet ist, z. B. ein positives Potential (VDD) von einigen Volt einerseits und ein Massenpotential (VSS) von null Volt andererseits.

Es muß sichergestellt werden,daß die Schaltereinrichtung, wenn sie gesperrt ist, kein Signal auf den Ausgang durchläßt. Es hat sich gezeigt, daß es bei Multiplexern, an die ein Analog/Digital-Wandler angeschlossen ist, häufig zu Nebensprechen kommt. D.h., das Signal in einem geöffneten Kanal, dessen Schaltereinrichtung durchgeschaltet ist, unterliegt Störungen,die von an sich gesperrten anderen Kanälen herstammen.

Aus der US-A-4 544 854 ist bekannt, daß solche Störungen davon herrühren können, daß Feldeffekttransistoren in dem Betriebsbereich, in dem sie eigentlich sperren sollen, Leckströme aufweisen, die zudem noch stark temperaturabhängig sind. Diese Leckströme lassen sich aus der logarithmischen Kennlinie von Feldeffekttransistoren erklären, aufgrund welcher im Sperrbereich bereits kleine Ströme fließen, nämlich die Leckströme. Bei dem in der US-A-4 544 854 gezeigten Analogschalter wird der Einfluß der Leckstromstörungen dadurch ausgeschaltet, daß jeder Analogschalter zwei in Reihe geschaltete Schalttransistoren aufweist und daß die Spannung am gemeinsamen Ausgang aller Kanäle auf den Verbindungspunkt zwischen den beiden Transistoren eines jeden geschlossenen Kanals rückgekoppelt wird. Dadurch entsteht über dem auf der Ausgangsseite des jeweiligen Kanals befindlichen Transistor eine Spannung Null, so daß keine Beeinflußung des Signals des jeweils durchgeschalteten Kanals entsteht.

Eine andere Störsignalquelle sind kapazitive Ströme oder Verschiebeströme, die über gesperrten Feldeffekttransistoren entstehen und zu unerwünschten Ausgangssignalen an gesperrten Kanälen führen. Mit dieser Störerscheinung befaßt sich die EP-A1-0091265, aus welcher eine Schaltereinrichtung mit vielen der eingangs angegebenen Merkmale bekannt ist. Der in dieser Druckschrift beschriebenen Maßnahme liegt die Erkenntnis zugrunde, daß über die Source-Drain-Kapazität eines gesperrten Feldeffekttransistors ein am Eingang anliegendes Wechselsignal unerwünschterweise auf den Ausgang durchgreift. Bei der aus dieser Druckschrift bekannten Schaltereinrichtung wird diesem Effekt dadurch entgegengewirkt, daß jeder Kanal zwei hintereinandergeschaltete Feldeffekttransistoren aufweist und der Verbindungspunkt zwischen diesen beiden Feldeffekttransistoren (FET) über einen Klemm-Feldeffekttransistor (Klemm-FET) mit einem konstanten Potential, vorzugsweise Masse, verbunden ist. Im gesperrten Schaltzustand der beiden FET ist der Klemm-FET leitend geschaltet, so daß über die Source-Drain-Kapazität des ersten FET durchgelassene Störsignale zu Masse hin kurz-geschlossen werden.

Trotz dieser bekannten Störunterdrückungsmaßnahmen können erhebliche Störungen auftreten, wenn das Eingangssignal der Schaltereinrichtung über das eine oder das andere Ende des Betriebsspannungsbereichs hinausgeht.

Solche Störungen treten auch bei der Schaltereinrichtung auf, die aus der bereits genannten Veröffentlichung E. D. N. ELECTRICAL DESIGN NEWS bekannt ist. Dort ist der Eingang mit dem Ausgang über eine Reihenschaltung Zweier Paare komplementärer FET verbunden. Ein Verbindungspunkt zwischen diesen beiden Paaren ist über ein drittes Paar komplementärer FET mit Masse verbunden. D. h., unabhängig davon, ob gerade die P-Kanal-FET oder die N-Kanal-FET der beiden Paare komplementärer FET gesperrt sind, wird mit dem dritten Paar komplementärer FET immer eine Klemmung in Richtung Masse, d. h. zum negativen Ende des Eingangsspannungsbereichs hin vorgenommen.

Wie nachfolgend noch ausführlich erläutert wird, bleibt auf diese Weise eine gewisse, unerwünschte Leitfähigkeit in dem Signalweg enthalten, die dann, wenn eine derartige Schaltereinrichtung in einem Multiplex-System verwendet wird, in einem anderen, gerade auf Signalübertragung geschalteten Kanal des Multiplexsystems Nebensprechen hervorrufen kann.

Der Erfindung liegt die Aufgabe zugrunde, eine Abhilfe gegen derartige Störungen aufgrund von Überschreitungen des Betriebsspannungsbereichs durch das Eingangssignal zu schaffen, auch wenn am Signalweg N-Kanal-FETs beteiligt sind.

Eine Lösung dieser Aufgabe ist im Anspruch 1 angegeben. Eine Ausführungsform der Erfindung besteht in einer als integrierte Schaltung ausgebildeten Schaltereinrichtung, die zwischen einem Eingang und einem Ausgang ein erstes Paar komplementärer Schalter-FET, die je nur innerhalb eines vorbestimmten Eingangsspannungsbereichs vollständig abschalten und bei Erhalt eines Steuersignals ein Eingangssignal durchschalten, und ein zweites Paar komplementärer Schalter-FET, das zwischen das erste Paar komplementärer Schalter-FET und den Ausgang geschaltet ist und synchron mit dem ersten Paar komplementär Schalter-FET gesteuert wird, aufweist.

Dabei weist die Schaltereinrichtung zwischen dem Eingang und dem Ausgang zwei parallele Signalwege auf. Ein erster Signalweg weist die P-Kanal-Schalter-FET und der zweite Signalweg weist die N-Kanal-Schalter-FET der beiden Paare komplementärer Schalter-FET auf. Der N-Kanal-Klemm-FET klemmt im durchgeschalteten Zustand einen Schaltungspunkt zwischen den beiden P-Kanal-Schalter-FET auf eine negative Betriebsspannung. Der P-Kanal-Klemm-FET klemmt im durchgeschalteten Zustand einen Schaltungspunkt zwischen den beiden N-Kanal-Schalter-FET auf eine positive Betriebsspannung.

Eine Ausführungsform der Erfindung mit nur einem einzigen Signalweg zwischen dem Eingang und dem Ausgang besteht in einer als integrierte Schaltung ausgebildeten Schaltereinrichtung, die zwischen einem Eingang und einem Ausgang ein erstes Paar komplementärer Schalter-FET, das nur innerhalb eines vorbestimmten Eingangsspannungsbereichs vollständig abschaltet und bei Erhalt eines Steuersignals ein Eingangssignal durchschaltet, und ein zweites Paar komplementärer Schalter-FET, das zwischen dem ersten Paar komplementärer Schalter-FET und dem Ausgang angeordnet und synchron mit dem ersten Paar komplementärer Schalter-FET gesteuert wird, aufweist.

Zwischen das zweite Paar komplementärer Schalter-FET und den Ausgang ist ein drittes Paar komplementärer Schalter-FET geschaltet, das synchron mit dem ersten und dem zweiten Paar komplementärer Schalter-FET geschaltet wird. Zwischen dem zweiten und dem dritten Paar komplementärer Schalter-FET ist ein zweiter Klemm-FET angeordnet, der einen zwischen dem zweiten und dem dritten Paar komplementärer Schalter-FET liegenden zweiten Schaltungspunkt auf ein zweites Ende des Eingangsspannungsbereiches klemmt. Zum Klemmen auf das positive Ende des Eingangsspannungsbereichs wird ein P-Kanal-Klemm-FET und zum Klemmen auf das negative Ende des Eingangsspannungsbereichs wird ein N-Kanal-Klemm-FET verwendet. Der zweite Klemm-FET ist im Abschaltzustand des ersten, des zweiten und des dritten Paares komplementärer Schalter-FET eingeschaltet und umgekehrt.

Je nach Art des Eingangssignals kann ein einziger Signalweg ausreichen, der in Reihenschaltung zwei Schalter-FET gleichen Kanal-Typs aufweist, deren Verbindungspunkt mittels eines Klemm-FET entgegengesetzten Kanaltyps auf eine konstante Spannung geklemmt wird, wenn die beiden Schalter-FET gleichzeitig in ihren Sperrzustand geschaltet sind. Sind die beiden Schalter-FET P-Kanal-Schalter-FET, erfolgt die Klemmung auf die negative Betriebsspannung. Handelt es sich bei den beiden Schalter-FET um N-Kanal-Schalter-FET, erfolgt erfindungsgemäß eine Klemmung auf die positive Betriebsspannung.

Vorzugsweise ist dem Eingang der Schaltereinrichtung eine Schutzschaltung, insbesondere Diodenschutzschaltung vorgeschaltet, wie dies an sich bekannt ist aus "elektronik industrie", Bd. 6, 1984, S. 74, 78 bis 80.

Weitere vorteilhafte Ausgestaltungen der Erfindung sind in den abhängigen Ansprüchen angegeben.

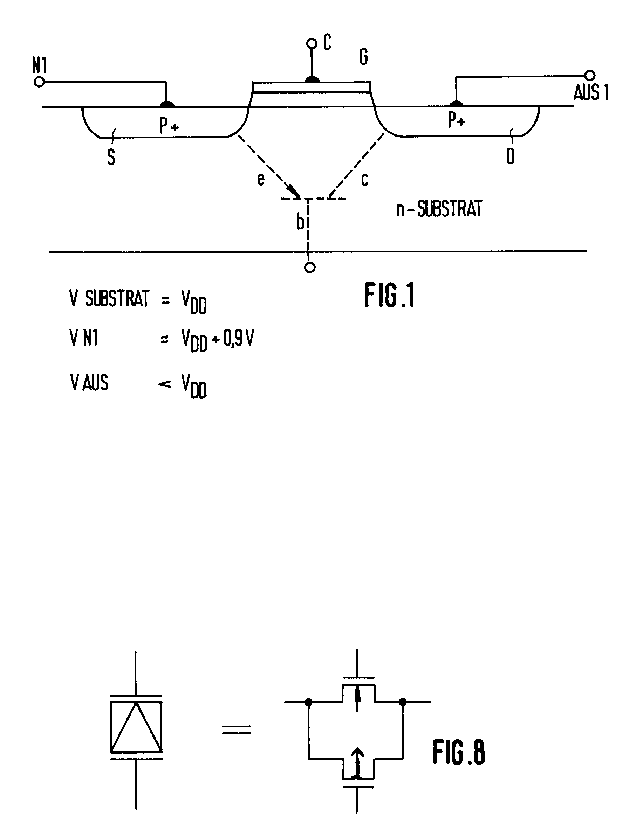

Ein wesentlicher Schritt für die erfindungsgemäße Lösung, mit welcher solche Störungen überwunden werden können, bestand in der Erkenntnis, daß für Störungen dieser Art parasitäre Bipolar-Effekte in Feldeffekttransistoren verantwortlich zu machen sind. Diese Bipolar-Effekte werden nun anhand von Figur 1 erläutert, die einen Chip-Querschnitt eines P-Kanal-MOS-Transistors zeigt. Dabei sind Source S und Drain D je durch eine P+-dotierte Zone gebildet, die sich in einem N-leitenden Substrat befinden. Zwischen Source S und Drain D befindet sich ein Kanal, der über das Potential der Gateelektrode G gesteuert wird. Die Sourceelektrode ist über einen Anschluß N1 an den Eingang der Schaltereinrichtung angeschlossen. Die Drainelektrode ist an einen Ausgang AUS1 der Schaltereinrichtung angeschlossen. Über den Steueranschluß C wird der MOS-Transistor leitend oder sperrend geschaltet. Zwischen Source-Zone, Substrat und Drainzone bildet sich ein parasitärer Bipolar-Transistor aus, der in Figur 1 gestrichelt dargestellt ist. Dabei bildet die Source den Emitter, die Drain den Kollektor und das Substrat die Basis eines PNP-Bipolartransistors. Da sich das Substrat eines solchen P-Kanal-MOS-Transistors auf dem positiven Potential V_{DD}
befindet, leitet dieser Bipolar-Transistor dann nicht, wenn die Eingangsspannung die Betriebsspannung V_{DD} nicht übersteigt. Steigt die Eingangsspannung jedoch um mehr als die Schwellenspannung eines Bipolartransistors über V_{DD} an, gerät der Bipolartransistor in den leitenden Zustand, solange am Ausgang AUS1 von einem anderen Kanal eine Spannung zugeführt wird, die kleiner ist als V_{DD}. Die aufgrund solcher Bipolareffekte verursachten Störsignale weisen üblicherweise eine Stärke auf, die erheblich über derjenigen von Störsignalen aufgrund von Leckströmen und kapazitiver Kopplung liegt.

Bei Schaltereinrichtungen, die mit N-Kanal-FET aufgebaut sind, treten die gleichen störenden Bipolareffekte auf, wenn die Eingangsspannung die Betriebsspannung auf der negativen Seite übersteigt und der Ausgangsseite von anderen Kanälen eine Spannung aufgeprägt wird, die positiver ist als die an der Basis des parasitären Bipolartransistors liegende Spannung.

Weswegen bei der bekannten Schaltereinrichtung gemäß der EP-A1-0091265 Störungen, die dadurch hervorgerufen werden, daß das Eingangssignal den Betriebsspannungsbereich übersteigt, nicht ausgeschaltet werden, läßt sich erklären wie folgt:

Bekanntlich verwendet man zum Durchschalten auf negatives Potential N-Kanal-FET, während man zum Durchschalten von positivem Potential P-Kanal-FET benutzt. Dadurch wird ein Spannungsabfall in der Höhe der Durchschalt-Schwellenspannung vermieden, der bei Verwendung von FET entgegengesetzter Leitfähigkeit auftreten würde. Aus diesem Grund ist es nur sinnvoll, den Klemmtransistor bei der aus der EP-A1-0091265 bekannten Schaltung als N-Kanal-FET auszubilden. Da der Klemm-FET dann leitend geschaltet wird, wenn die hintereinandergeschalteten FET gesperrt sind und umgekehrt, andererseits an die Gate-Elektroden der hintereinandergeschalteten FET ein Steuersignal angelegt wird, das zu dem des Klemm-FET komplementär ist, muß es sich auch bei den hintereinandergeschalteten FET um N-Kanal-FET handeln. Bei Verwendung von P-Kanal-FET ließe sich das Kurzschließen des Verbindungspunktes zwischen den zwei hintereinandergeschalteten FET auf Masse nur mangelhaft erreichen, da in Wirklichkeit nur eine Klemmung auf ein Potential entstünde, das um die Durchschalt-Schwellenspannung höher läge als Masse.

Das gleiche Problem entsteht, wenn bei der aus der genannten Veröffentlichung E. D. N. ELECTRICAL DESIGN NEWS bekannten Schaltung der Signalweg durch die N-Kanal-Schalter-FET der komplementären Schalter-FET-Paare betrachtet wird. Denn auch in diesem Fall erfolgt bei der bekannten Schaltung die Klemmung auf Masse und nicht auf die positive Betriebsspannung, wie es erfindungsgemäß gefordert wird. Störungen aufgrund des Übersteigens der Betriebsspannung auf der negativen Seite infolge der Auswirkung von Bipolareffekten werden hier verhindert.

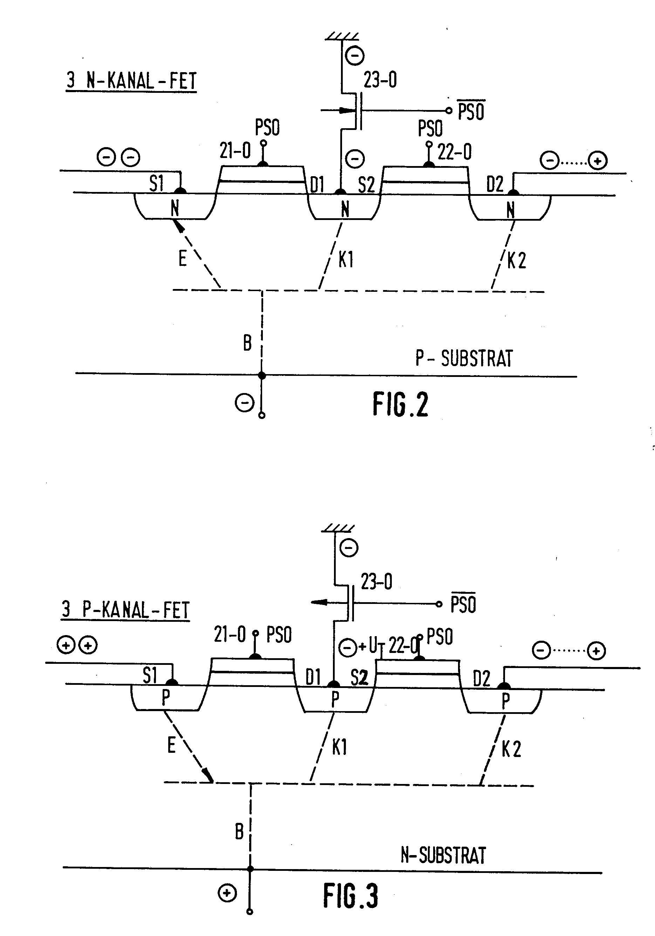

In Fig. 2 ist in Schnittdarstellung eine Feldeffekttransistorstruktur gezeigt, in der die parasitäre Bipolarstruktur angegeben ist. Betrachtet man in Fig. 2 der EP-A1-0091265 den oberen Kanal mit den hintereinander geschalteten FET 21-0 und 22-0, entspricht in Fig. 2 der linke FET mit der Source S1 und der Drain D1 dem FET 21-0, während die Struktur mit der Source S2 und der Drain D2 dem FET 22-0 entspricht. Der elektrisch gemeinsame Schaltungspunkt von D1 und D2 ist über den Klemm-FET 23-0 mit Masse verbunden.

Bei einer N-Kanal-FET-Struktur wird das Substrat üblicherweise auf das negative Betriebsspannungspotential gelegt. Ist die am Eingang der Schaltereinrichtung auftretende Signalspannung um die Emitter-Basis-Durchlaßspannung eines Bipolartransistors niedriger als das negative Betriebsspannungspotential, kann der parasitäre Bipolartransistor bei entsprechendem Kollektorpotential leiten. Wird dem Ausgang der Schaltereinrichtung von einem anderen Kanal ein Potential aufgeprägt, das positiver ist als das an der Basis des parasitären Bipolartransistors anliegende negative Betriebsspannungspotential, gelangt der Bipolartransistor mit dem mit S1 übereinstimmenden Emitter E, der mit dem Substrat übereinstimmenden Basis B und dem mit D2 übereinstimmenden Kollektor K2 in den Leitzustand, so daß am Ausgang der Schaltereinrichtung ein entsprechendes Störsignal auftritt. Die Bipolarstruktur weist einen weiteren Kollektor

K1 auf, der mit D1 bzw. S2 übereinstimmt und über den N-FET 23-0 im ausgeschalteten Zustand der Schaltereinrichtung auf Massepotential, d. h., das negative Betriebsspannungspotential, gelegt wird. Bei diesem Potential hat der Kollektor K1 keine Absaugwirkung, so daß der gesamte Bipolarstrom zum Kollektor K2 und damit unerwünschterweise zum Ausgang der Schaltereinrichtung gelangt.

Aus RUNDFUNKTECHNISCHE MITTEILUNGEN, Band 20, Nr. 6, Dezember 1976, Seiten 247-253, ist ein Analogschalter bekannt, der in gleicher Weise wie die Schaltereinrichtung gemäß EP-A1-0091265 aufgebaut ist, wobei jedoch alle Transistoren durch P-Kanal-FET gebildet sind. Für eine derartige Schaltereinrichtung ist die entsprechende Halbleiterstruktur in Fig. 3 gezeigt. In dieser sind Halbleiterzonen, die denen der Struktur in Fig. 2 entsprechen, mit gleichen Bezugszeichen gekennzeichnet. Bei einer solchen P-Kanal-Struktur liegt das Substrat auf positivem Betriebsspannungspotential. Wird die Eingangsspannung um den Betrag der Emitter-Basis-Durchlaßspannung eines Bipolartransistors höher als das positive Betriebsspannungspotential, leitet die Emitter-Basis-Diode der Bipolar-Struktur. Ist das Potential, das dem Kollektor K2 der Bipolar-Struktur von einem anderen Kanal aufgeprägt wird, niedriger als das positive Betriebsspannungspotential, entsteht ein leitender Bipolartransistor E, B, K2. Über den P-Kanal-Klemm-FET 23-0 wird im gesperrten Zustand der Schaltereinrichtung an K1 ein Potential angelegt, das um die Durchlaßschwellenspannung U_{T} des FET 23-0 höher ist als das negative Betriebsspannungspotential. D. h. daß der Bipolartransistor E, B, K1 ebenfalls leitet. Dadurch wird zwar der vom Kollektor K2 absaugbare Strom vermindert. Der am Kollektur K2 auftretende Strom ist jedoch immer noch so groß, daß er am Ausgang der Schaltereinrichtung beträchtliche Störungen versursacht.

Diese Probleme sind mit der vorliegenden Erfindung beseitigt worden. Dadurch, daß der Klemm-FET erfindungsgemäß von einem Leitfähigkeitstyp ist, der zu dem der beiden hintereinander geschalteten FET entgegengesetzt ist, wird erreicht, daß der Kollektorstrom der parasitären Bipolar-Struktur immer vollständig über den Klemm-FET abgeleitet wird und am Kollektor K2 praktisch kein Ausgangsstrom fließt.

Im folgenden werden Ausführungsbeispiele der Erfindung anhand der Zeichnung näher erläutert. Es zeigen:
- Figur 1: ein Schnittbild eines P-Kanal-MOS-Transistors mit parasitärem Bipolartransistor;
- Figur 2: eine Schnittstruktur zweier hintereinander geschalteter N-Kanal-MOS-Transistoren mit parasitärer Bipolarstruktur;
- Figur 3: ein Schnittbild zweier hintereinander geschalteter P-Kanal-MOS-Transistoren mit parasitärer Bipolarstruktur;
- Figur 4: ein Schaltbild einer ersten bevorzugten Ausführungsform der Erfindung;
- Figur 5: eine Schnittstruktur der beiden in Figur 4 unteren hintereinandergeschalteten N-Kanal-Schalter-FET mit der parasitären Bipolarstruktur;
- Figur 6: eine Schnittstruktur der in Figur 4 oberen beiden hintereinandergeschalteten P-Kanal-Schalter-FET mit parasitärer Bipolarstruktur;
- Figur 7: das Schaltbild einer zweiten bevorzugten Ausführungsform der Erfindung; und
- Figur 8: einen CMOS-Schalter der in Figur 7 nur symbolhaft dargestellten Art.

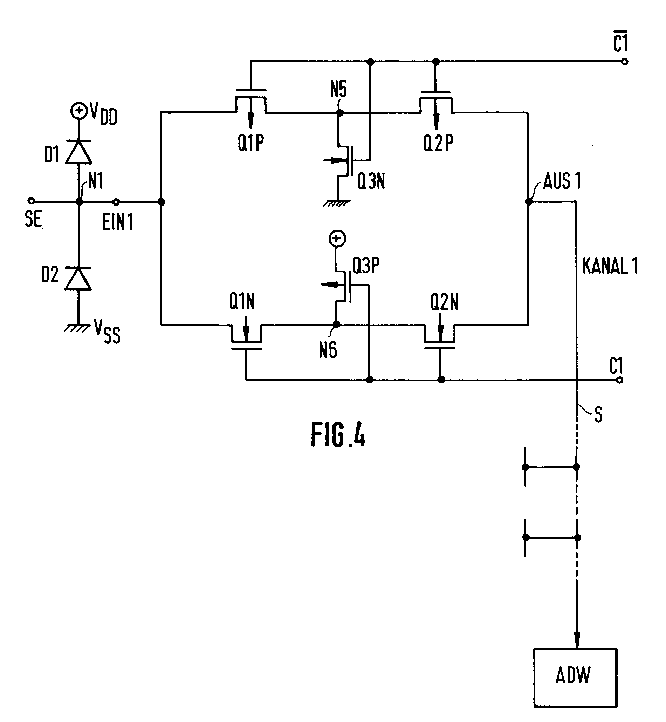

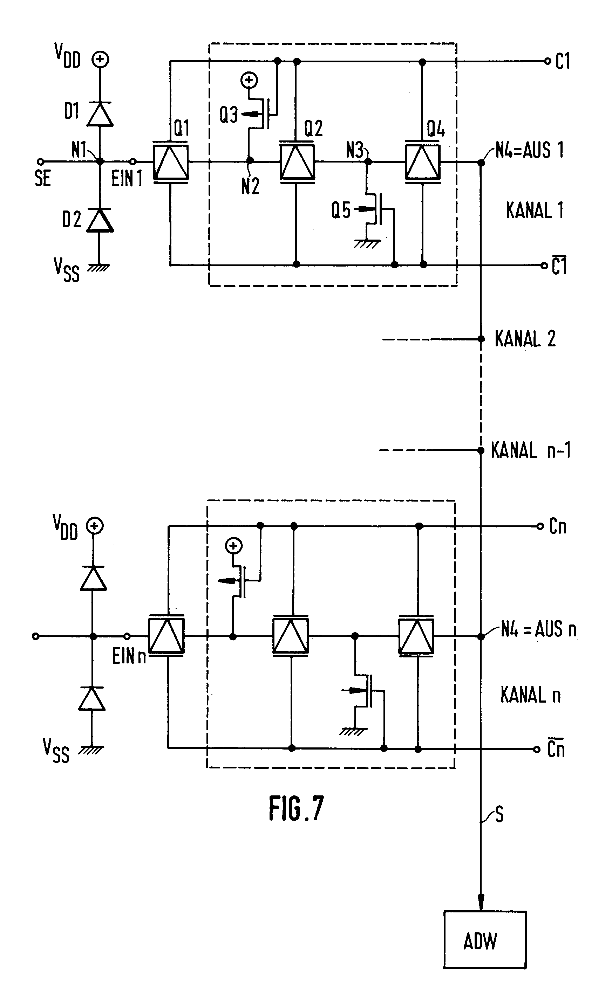

Der im folgenden anhand der Figuren 4 und 7 näher erläuterte Analogsignal-Multiplexer ist monolithisch auf einem Chip ausgebildet, wobei der Chip an eine Versorgungsspannungsquelle angeschlossen ist, die das positive Potential V_{DD} und das Massepotential V_{SS} liefert. Der Multiplexer eignet sich besonders für Analog/Digital-Wandler (ADW), ist jedoch auf für andere Anwendungsfälle geeignet.

Die in den Figuren 4 und 7 gezeigten Multiplexer enthalten n Kanäle, von denen in Figur 1 nur der erste Kanal und in Figur 7 nur der erste und der letzte Kanal dargestellt sind. Die nicht-gezeigten Kanäle sind identisch zu den gezeigten Kanälen aufgebaut. Es wird daher im folgenden jeweils nur der erste Kanal beschrieben und betrachtet.

Bei der in Figur 4 gezeigten Ausführungsform weist jeder Kanal eine Schaltereinrichtung mit zwei parallelen Signalzweigen auf. Die Schaltereinrichtung des Kanals 1 weist einen Eingang EIN1 auf, der zusammen mit einem Signaleingang SE einen ersten Schaltungsknoten N1 bildet, an den eine Diodenschutzschaltung mit zwei in Reihe geschalteten Dioden D1 und D2 angeschlossen ist. Die Diodenschutzschaltung ist zwischen das positive Potential V_{DD} und das Masse- oder negative Potential V_{SS} einer Betriebsspannungsguelle geschaltet.

Zwischen dem Eingang EIN1 und einem Ausgang AUS1 des Kanals 1 befinden sich die zwei Signalzweige der Schaltereinrichtung. Der in Figur 4 obere Signalzweig weist zwei in Reihe geschaltete P-Kanal-Schalter-FET Q1P und Q2P auf. Der in Figur 4 untere Signalzweig weist zwei in Reihe geschaltete N-Kanal-Schalter-FET Q1N und Q2N auf. Ein Verbindungspunkt N5 zwischen Q1P und Q2P ist über einen N-Kanal-Klemm-FET Q3N mit Masse verbunden. Ein Verbindungspunkt N6 zwischen Q1N und Q2N ist über einen P-Kanal-Klemm-FET Q3P mit V_{DD} verbunden. Die Steuerelektroden der drei FET Q1N, Q2N, Q3P des unteren Signalweges sind gemeinsam mit einer Steuersignalquelle C1 verbunden und die Steuerelektroden der drei FET Q1P, Q2P, Q3N des oberen Signalzweiges sind mit einer Steuersignalquelle C̅1̅ verbunden, deren Steuersignale komplementär zu denen der Steuersignalquelle C1 sind.

Für die Erfindung sind nun folgende Merkmale wesentlich:
- die beiden hintereinander geschalteten Schalter-FET eines jeden Signalzweiges sind von gleichem Leitfähigkeitstyp.
- Der Klemm-FET eines jeden Signalzweiges ist von einem Leitfähigkeitstyp, der zu dem Leitfähigkeitstyp der je zugehörigen beiden hintereinander geschalteten Schalter-FET entgegengesetzt ist.
- Der N-Kanal-Klemm-FET verbindet den Schaltungsknoten zwischen den zugehörigen hintereinander geschalteten Schalter-FET mit Masse bzw. dem negativen Potential der Betriebsspannungsquelle.
- Der P-Kanal-Klemm-FET verbindet den Schaltungsknoten zwischen den zugehörigen beiden hintereinander geschalteten Schalter-FET mit dem positiven Potential der Betriebsspannungsquelle.

Die in Figur 4 gezeigte Schaltung funktioniert folgendermaßen:
An den Signaleingängen SE der einzelnen Kanäle stehen Analogsignale an, die zu einem Analog/Digital-Wandler ADW durchgeschaltet werden sollen. Mit Hilfe der den Steuerelektroden der Schalter-FET zugeführten Steuersignale wird jeder Kanal während einer ihm vorbehaltenen Zeitspanne leitend geschaltet, während die restlichen Kanäle gesperrt sind. Wenn das Analogsignal von dem Eingang EIN1 des Kanals 1 auf den Ausgang AUS1 gelangt, der mit den Ausgängen aller anderen Kanäle und mit dem Eingang des ADW verbunden ist, sind die übrigen Kanäle gesperrt.

Die Diodenschutzschaltung D1, D2 schützt die Schaltereinrichtung vor positiven und negativen Überspannungen. Übersteigt das eingangsseitige Analogsignal das positive Potential V_{DD} der Betriebsspannung um einen bestimmten Wert, wird die Diode D1 leitend, wobei an der Diode D1 deren Durchlaßspannung von etwa 0,7 bis 0,9 V abfällt. Unterschreitet das eingangsseitige Analogsignal das negative Potential V_{SS} der Betriebsspannungsquelle um einen bestimmten Wert, wird die Diode D2 leitend, wobei an der Diode D2 ebenfalls deren Durchlaßspannung von etwa 0,7 bis 0,9 V abfällt. Während der Zeitspanne, während welcher der Kanal 1 ausgewählt ist, sind die Schalter-FET Q1P, Q2P und Q1N, Q2N in den beiden Signalzweigen leitend und die beiden Klemm-FET Q3N und Q3P sperrend geschaltet, so daß das dem Eingang EIN1 zugeführte Analogsignal über den Ausgang AUS1 zum ADW gelangt. Ist Kanal 1 nicht ausgewählt, werden die Klemm-FET Q3N und Q3P leitend geschaltet.

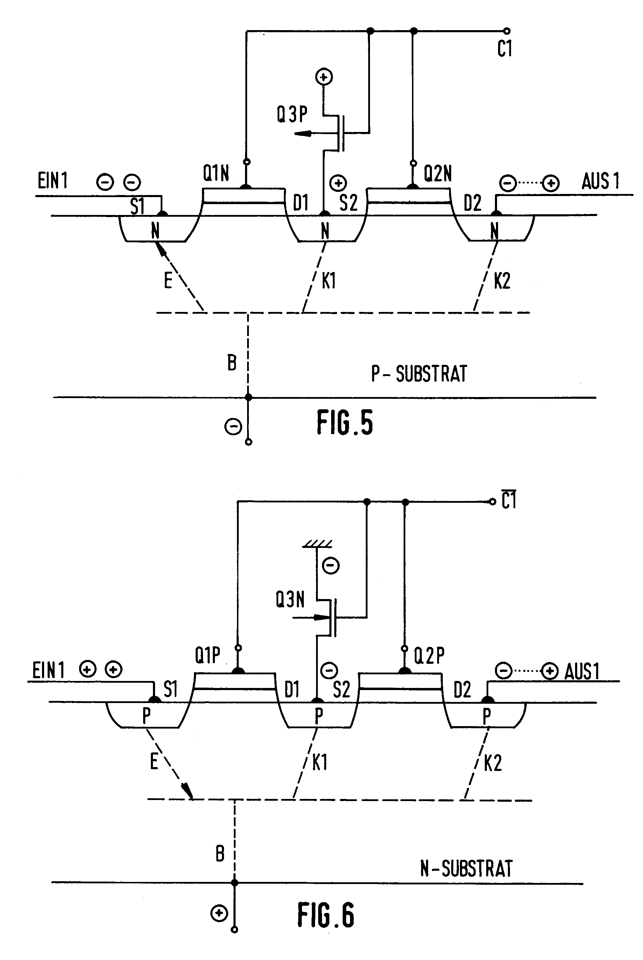

Was die erfindungsgemäßen Maßnahmen bewirken, wird nun anhand von Figur 5 für den in Figur 4 oberen Signalweg und anhand von Figur 6 für den in Figur 4 unteren Signalweg erläutert. Dabei werden für übereinstimmende Merkmale die gleichen Bezugszeichen wie in den Figuren 2 und 3 verwendet.

Figur 5 zeigt den Querschnitt einer Halbleiterstruktur mit den zwei N-Kanal-Schalter-FET Q1N und Q2N des in Figur 4 unteren Signalweges. Das P-leitende Substrat bildet die Basis der parasitären Bipolarstruktur und liegt üblicherweise auf Massepotential bzw. dem negativen Potential V_{SS} der Betriebsspannungsquelle. Die N-leitende Source S1 des Schalter-FET Q1N bildet den Emitter der parasitären Bipolarstruktur. Diese weist zwei Kollektoren K1 und K2 auf, wobei Kollektor K1 durch die N-leitende Zone gebildet wird, die einerseits die Drain D1 von Q1N und anandererseits die Source S2 von Q2N bildet. Der zweite Kollektor K2 wird durch die N-leitende Drainzone D2 von Q2N gebildet. Die parasitäre Bipolar-Struktur bildet somit einen PNP-Transistor mit zwei Kollektoren.

Bei gesperrten Schalter-FET Q1N und Q2N liegt der Kollektor K1 über den Klemm-FET Q3P auf dem positiven Potential V_{DD} der Betriebsspannungsquelle. Das Potential des Kollektors K2 kann in Abhängigkeit davon, welches Ausgangssignal der jeweils leitende Kanal auf den gemeinsamen Ausgangsknotenpunkt S gibt, zwischen dem positiven Potential V_{DD} und dem negativen Potential V_{SS} der Betriebsspannungsquelle liegen. Weist das eingangsseitige Analogsignal Überspannung zur negativen Seite hin auf, weist der Emitter E ein Potential auf, das negativer ist als V_{SS}.

Zur anschaulicheren Darstellung sind in den Figuren 2, 3, 5 und 6 das positive Potential V_{DD} mit 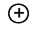 , das negative Potential V_{SS} mit 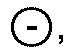 , eine Überspannung zur positiven Seite mit 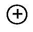 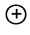 und eine Überspannung zur negativen Seite hin mit 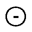 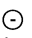 dargestellt. Bei negativer Überspannung, welche mindestens um die Durchlaßspannung einer Emitter-Basis-Diode niedriger liegt als V_{SS}, leitet die Emitter-Basis-Diode des parasitären Bipolartransistors in Figur 5. Da Kollektor K1 auf dem positiven Potential V_{DD} liegt, leitet der Bipolartransistor E-B-K1 stark. Selbst wenn am Kollektor K2 ein Potential auftritt, das ein Leiten des Bipolartransistors E-B-K2 verursacht, bleibt für den Kollektor K2 praktisch kein Strom übrig. Denn das Potential des Kollektors K1 ist allenfalls so positiv wie das des Kollektors K1. Da sich die Kollektorzone des Kollektors K1 dichter beim Emitter E befindet als die Kollektorzone des Kollektors K2 und die Stromverstärkung eines Bipolartransistors um so höher ist, je kürzer die Basiszone zwischen Emitter und Kollektor ist, zieht Kollektor K1 in jedem Fall einen wesentlich höheren Strom als Kollektor K2. Kollektor K1 gräbt dem Kollektor K2 sozusagen den Strom ab.

Entsprechende Überlegungen gelten für die in Figur 6 gezeigte Halbleiterstruktur für die beiden hintereinander geschalteten P-Kanal-Schalter-FET Q1P und Q2P des in Figur 4 oberen Signalweges. Bei positiver Überspannung am Emitter kommt es zu einem starken Leiten des Bipolartransistors E-B-K1, während der Bipolartransistor E-B-K2 praktisch keinen Kollektorstrom führen kann, weil sein Potential im allgemeinen positiver als das des Kollektors K1 ist, allenfalls gleich hoch, und weil die Kollektorzone des Kollektors K2 vom Emitter E weiter ab liegt als die Kollektorzone des Kollektors K1.

Störsignale, die im Fall bekannter Schaltungen bei eingangsseitiger Überspannung am Ausgang einer gesperrten Schaltereinrichtung auftreten, sind durch die erfindungsgemäßen Maßnahmen praktisch beseitigt, da die Störeffekte leitender parasitärer Bipolarstrukturen vom Ausgang der Schaltereinrichtung abgehalten werden.

Figur 7 zeigt eine Ausführungsform der Erfindung, bei welcher die Schaltereinrichtung eines jeden Kanals nur einen Signalpfad aufweist, der die Hintereinanderschaltung dreier Schalter besitzt, die je durch ein Symbol dargestellt sind, das eine Parallelschaltung zweier komplementärer Schalter-FET bedeutet, wie dies in Figur 8 gezeigt ist.

Hinsichtlich der Diodenschutzschaltung stimmt die Ausführungsform nach Figur 7 mit der in Figur 4 gezeigten Ausführungsform überein.

Zwischen dem ersten Paar Q1 komplementärer Schalter-FET und dem zweiten Paar Q2 komplementärer Schalter-FET befindet sich ein Schaltungsknoten N2, der über einen ersten Klemm-FET Q3 mit dem positiven Potential V_{DD} der Betriebsspannungsquelle verbunden ist. Zwischen dem zweiten Paar Q2 komplementärer Schalter-FET und dem dritten Paar Q4 komplementärer Schalter-FET befindet sich ein zweiter Schaltungsknoten N3, der über einen zweiten Klemm-FET Q5 mit dem negativen Potential V_{SS} der Betriebsspannungsquelle verbunden ist. Die N-Kanal-Schalter-FET der Transistorpaare Q1 und Q2 werden mit Hilfe des ersten Klemm-FET Q3 in der Weise vor den Folgen eingangsseitiger negativer Überspannungen geschützt, wie es anhand von Figur 5 erläutert worden ist. Die P-Kanal-Schalter-FET der Transistorpaare Q2 und Q4 werden mit Hilfe des zweiten Klemm-FET Q5 vor den Auswirkungen positiver eingangsseitiger Überspannungen geschützt, wie es im Zusammenhang mit Figur 6 erläutert worden ist. Daher können eingangsseitige Überspannungen sowohl positiver als auch negativer Richtung keine Störwirkung auf den Ausgangsknoten N4 ausüben, der gleichzeitig den Ausgang AUS1 des Kanals 1 bildet.

Dabei werden die einzelnen Transistoren der Schaltereinrichtungen nach Figur 7 in gleicher Weise von den Steuersignalquellen C1 und C̅1̅ gesteuert, wie dies im Zusammenhang mit der Ausführungsform nach Figur 4 erläutert worden ist.

In jedem der Kanäle 1-n bilden die Transistorpaare Q2, Q4 und die Klemm-FET Q3, Q5 eine gestrichelt eingerahmte Schutzschaltung, mit welcher das Durchgreifen von störenden eingangsseitigen Überspannungen auf den Ausgang eines gesperrten Kanals unterbunden wird.

Besonders gute Ergebnisse erhält man mit den erfindungsgemäßen Maßnahmen dann, wenn in der räumlichen Struktur der integrierten Schaltung mit der erfindungsgemäßen Schaltereinrichtung die mit den Klemm-FET geklemmten Schaltungspunkte näher an dem möglicherweise Überspannungen ausgesetzten Eingang liegen als der Ausgangspunkt der Schaltereinrichtung.

Für manche Anwendungsfälle mag es ausreichend sein, für jeden Kanal nur den oberen oder den unteren Signalweg der in Figur 4 gezeigten Schaltereinrichtung zu verwenden, entsprechend der in Figur 2 der EP-A1-0091265 gezeigten Schaltung. Im Gegensatz zu dieser bekannten Schaltung muß aber erfindungsgemäß der Leitfähigkeitstyp des Klemm-FET entgegengesetzt zu dem Leitfähigkeitstyp der den Signalweg bildenden hintereinander geschalteten Schalter-FET sein und muß der mit den P-Kanal-Schalter-FET zusammenwirkende Klemm-FET mit dem negativen und der mit den N-Kanal-Schalter-FET zusammenarbeitende Klemm-FET mit dem positiven Potential der Betriebsspannungsquelle verbunden sein.

## Patentansprüche

1. Als integrierte Schaltung ausgebildete Schaltereinrichtung,
mit einem Eingang (EIN1) und einem Ausgang (AUS1),
mit einem Betriebsspannungsanschluß für ein positives Betriebsspannungspotential (VDD) und einem Betriebsspannungsanschluß für ein negatives Betriebsspannungspotential (VSS),
mit einem ersten steuerbaren Schalter in Form eines ersten N-Kanal-Schalter-FET (Q1N), der nur innerhalb eines vorbestimmten Spannungsbereiches (VSS) vollständig abschaltet und der bei Erhalt eines Steuersignals (C1) das am Eingang (EIN1) auftretende Eingangssignal durchschaltet,
mit einem zu dem ersten N-Kanal-Schalter-FET (Q1N) in Reihe geschalteten, zwischen dem ersten N-Kanal-Schalter-FET (Q1N) und dem Ausgang (AUS1) der Schaltereinrichtung vorgesehenen zweiten steuerbaren Schalter in Form eines zweiten N-Kanal-Schalter-FET (Q2N), der synchron mit dem ersten N-Kanal-Schalter-FET (Q1N) gesteuert wird,
mit einem P-Kanal-Klemm-FET (Q3P; Q3), der im durchgeschalteten Zustand einen gemeinsamen Schaltungsknoten (N6, N2) zwischen erstem N-Kanal-Schalter-FET (Q1N) und zweitem N-Kanal-Schalter-FET (Q2N) auf konstante Spannung legt und zeitlich synchron mit dem ersten N-Kanal-Schalter-FET (Q1N) und dem zweiten N-Kanal-Schalter-FET (Q2N) in einen dem Schaltzustand von erstem N-Kanal-Schalter-FET (Q1N) und zweitem N-Kanal-Schalter-FET (Q2N) jeweils entgegengesetzten Schaltzustand geschaltet wird,
wobei die beiden N-Kanal-Schalter-FET (Q1N, Q2N) in einem P-leitendem Substrat gebildet sind, das mit dem Betriebsspannungsanschluß für das negative Betriebsspannungspotential (VSS) verbunden ist,
und wobei die Gate-Elektrode aller drei FET (Q1N, Q2N, Q3N) mit Steuersignalen gleicher Polarität angesteuert werden,
**dadurch gekennzeichnet,**
daß die Klemmung durch den P-Kanal-Klemm-FET (Q3P) auf das positive Betriebsspannungspotential (VDD) erfolgt.

2. Schaltereinrichtung nach Anspruch 1,
**dadurch gekennzeichnet,**
daß zwischen dem Eingang (EIN1) und dem Ausgang (AUS1) zwei parallele Signalwege vorgesehen sind,
daß ein erster Signalweg die beiden N-Kanal-Schalter-FET (Q1N, Q2N) und den an deren gemeinsamen Schaltungspunkt (N6) angeschlossenen P-Klemm-FET (Q3P) aufweist,
daß der zweite Signalweg ein Paar in Reihe geschaltete P-Kanal-Schalter-FET (Q1P, Q2P) mit einem dazwischen befindlichen gemeinsamen Schaltungspunkt (N5), der über einen N-Kanal-Klemm-FET (Q3N) in dessen durchgeschaltetem Zustand auf das negative Betriebsspannungspotential (VSS) geklemmt wird, aufweist,
daß die beiden P-Kanal-Schalter-FET (Q1P, Q2P) in einem N-leitenden Substrat gebildet sind, das mit dem Anschluß für das positive Betriebsspannungspotential (VDD) verbunden ist,
wobei der mit dem Eingang (EIN1) verbundene erste P-Kanal-Schalter-FET (Q1P) nur innerhalb eines vorbestimmten Eingangsspannungsbereichs (VDD, VSS) vollständig abschaltet und bei Erhalt eines Steuersignals (C1, C̅1̅) ein Eingangssignal durchschaltet,
und daß der N-Kanal-Klemm-FET (Q3N) zeitlich synchron mit den beiden P-Kanal-Schalter-FET (Q1P, Q2P) in einen dem Schaltzustand der beiden P-Kanal-Schalter-FET (Q1P, Q2P) jeweils entgegengesetzten Schaltzustand geschaltet wird.

3. Schaltereinrichtung nach Anspruch 1,
**dadurch gekennzeichnet,**
daß zwischen dem Eingang (EIN1) und dem Ausgang (AUS1) drei in Reihenschaltung angeordnete Paare komplementärer Schalter-FET (Q1, Q2, Q4) bestehend aus je einem N-Kanal-Schalter-FET und einem dazu parallel geschalteten P-Kanal-Schalter-FET, liegen,
wobei der erste und der zweite N-Kanal-Schalter-FET den N-Kanal-FET des ersten bzw. des zweiten Paares (Q1, Q2) komplementärer Schalter-FET bilden,
wobei die N-Kanal-Schalter-FET in einem P-leitenden Substrat, das mit dem Betriebsspannungsanschluß für negatives Betriebsspannungspotential (VSS) verbunden ist, und die P-Kanal-Schalter-FET in einem N-leitenden Substrat, das mit dem Betriebsspannungsanschluß für positives Betriebsspannungspotential (VDD) verbunden ist, gebildet sind,
und wobei das erste Paar (Q1) komplementärer Schalter-FET nur innerhalb eines vorbestimmten Eingangsspannungsbereichs (VDD, VSS) vollständig abschaltet und bei Erhalt eines Steuersignals (C1, C̅1̅) ein Eingangssignal durchschaltet,
daß ein gemeinsamer Schaltungspunkt (N2) zwischen dem ersten (Q1) und dem zweiten (Q2) Paar komplementärer Schalter-FET über den P-Kanal-Klemm-FET (Q3) in dessen durchgeschaltetem Zustand auf das positive Betriebsspannungspotential (VDD) und ein gemeinsamer Schaltungspunkt (N3) zwischen dem zweiten (Q2) und dem dritten (Q4) Paar komplentärer Schalter-FET über einen N-Kanal-Klemm-FET (Q5) auf das negative Betriebsspannungspotential (VSS) geklemmt wird,
daß die drei Paare komplementärer Schalter-FET (Q1, Q2, Q4) synchron geschaltet werden
und daß die beiden Klemm-FET (Q3, Q5) zeitlich synchron mit den drei Paaren komplementärer Schalter-FET (Q1, Q2, Q4) in einen deren Schaltzustand entgegengesetzten Schaltzustand geschaltet werden.

4. Schaltereinrichtung nach einem der Ansprüche 1 bis 3, dadurch gekennzeichnet, daß dem Eingang (EIN1) der Schaltereinrichtung eine Schutzschaltung, insbesondere Diodenschutzschaltung (D1, D2), vorgeschaltet ist.

5. Schaltereinrichtung nach Anspruch 2 oder 4, wenn rückbezogen auf 2, dadurch gekennzeichnet, daß zwei Steuersignalquellen für komplementäre Steuersignale (C1, C̅1̅) vorgesehen sind und daß die Steuerelektroden der beiden Schalter-FET (Q1N, Q2N) und des Klemm-FET (Q3P) des einen Signalweges an die eine (C1) und die Steuerelektroden der zweiten Schalter-FET (Q1P, Q2P) und des Klemm-FET (Q3N) des anderen Signalweges an die andere Steuersignalquelle (C̅1̅) angeschlossen sind.

6. Schaltereinrichtung nach Anspruch 3 oder 4, wenn rückbezogen auf 3, dadurch gekennzeichnet, daß zwei Steuersignalquellen für komplementäre Steuersignale (C1, C̅1̅) vorgesehen sind
und daß die Steuerelektroden der N-Kanal-Schalter-FET und des P-Kanal-Klemm-FET (Q3) an die eine Steuersignalquelle (C1) und die Steuerelektroden der P-Kanal-Schalter-FET und des N-Kanal-Klemm-FET (Q5) an die andere Steuersignalquelle (C̅1̅) angeschlossen sind.

7. Schaltereinrichtung nach mindestens einem der Ansprüche 1 bis 6, dadurch gekennzeichnet, daß alle FET durch MOS-FET gebildet sind.

8. Multiplexer mit mehreren Kanälen (1...n), mit einer gesteuerten Schaltereinrichtung in jedem Kanal und mit einem allen Kanälen (1...n) gemeinsamen Ausgangsknoten (S), dadurch gekennzeichnet, daß die Kanäle (1...n) je eine Schaltereinrichtung nach mindestens einem der Ansprüche 1 bis 7 aufweisen.

9. Multiplexer nach Anspruch 8, dadurch gekennzeichnet, daß an den gemeinsamen Ausgangsknoten (S) ein Analog/Digital-Wandler angeschlossen ist.

## Claims

1. A switch means designed as an integrated circuit, comprising
- an input (IN1) and an output (OUT1),
- an operating voltage terminal for a positive operating voltage potential (VDD) and an operating voltage terminal for a negative operating voltage potential (VSS),
- a first controllable switch in the form of a first n-channel switch FET (Q1N) which switches off completely only within a predetermined voltage range (VSS) and which, upon receiving a control signal (C1), connects through the input signal occurring at the input (IN1),
- a second controllable switch in the form of a second n-channel switch FET (Q2N) which is connected in series to the first n-channel switch FET (Q1N) and is provided between the first n-channel switch FET (Q1N) and the output (OUT1) of the switch means and which is controlled in synchronism with the first n-channel switch FET (Q1N),
- a p-channel clamp FET (Q3P; Q3) which, in the connected-through state, puts a common circuit node (N6, N2) between the first n-channel switch FET (Q1N) and the second n-channel switch FET (Q2N) to a constant voltage and in time synchronism with the first n-channel switch FET (Q1N) and the second n-channel switch FET (Q2N) is switched into a switching state that is opposite to the switching state of the first n-channel switch FET (Q1N) and the second n-channel switch FET (Q2N) in each case,
- the two n-channel switch FETs (Q1N, Q2N) being formed in a p-conducting substrate connected to the operating voltage terminal for the negative operating voltage potential (VSS),
- and the gate electrode of all three FETs (Q1N, Q2N, Q3N) being driven with control signals of the same polarity,
**characterized** in
that the p-channel clamp FET (Q3P) effects clamping to the positive operating voltage potential (VDD).

2. A switch means according to claim 1,
characterized in
- that two parallel signal paths are provided between input (IN1) and output (OUT1),
- that a first signal path comprises the two n-channel switch FETs (Q1N, Q2N) and the p-clamp FET (Q3P) connected to the common circuit point (N6) thereof,
- that the second signal path comprises a pair of series-connected p-channel switch FETs (Q1P, Q2P) having a common circuit point which is located therebetween and clamped to the negative operating voltage potential (VSS) via an n-channel clamp FET (Q3N) in the connected-through state thereof,
- that the two p-channel switch FETs (Q1P, Q2P) are formed in an n-conducting substrate connected to the terminal for the positive operating voltage potential (VDD),
- the first p-channel switch FET (Q1P) connected to the input (IN1) switching off completely only within a predetermined input voltage range (VDD, VSS) and, upon receiving a control signal (C1, C̅1̅), connecting through an input signal,
- and in that the n-channel clamp FET (Q3N) is switched in time synchronism with the two p-channel switch FETs (Q1P, Q2P) into a switching state that is opposite to the switching state of the two p-channel switch FETs (Q1P, Q2P) in each case.

3. A switch means according to claim 1,
characterized in
- that three series-connected pairs of complementary switch FETs (Q1, Q2, Q4), each consisting of an n-channel switch FET and a p-channel switch FET, are located between input (IN1) and output (OUT1),
- the first and the second n-channel switch FET constituting the n-channel FET of the first and the second pair of (Q1, Q2) of complementary switch FETs, respectively,
- the n-channel switch FETs being formed in a p-conducting substrate connected to the operating voltage terminal for negative operating voltage potential (VSS) and the p-channel switch FETs being formed in an n-conducting substrate connected to the operating voltage terminal for positive operating voltage potential (VDD),
- and the first pair (Q1) of complementary switch FETs switching off completely only within a predetermined input voltage range (VDD, VSS) and, upon receiving a control signal (C1, C̅1̅), connecting through an input signal,
- that a common circuit point (N2) between the first (Q1) and the second (Q2) pair of complementary switch FETs is clamped to the positive operating voltage potential (VDD) via the p-channel clamp FET (Q3) in the connected-through state thereof and a common circuit point (N3) between the second (Q2) and the third (Q4) pair of complementary switch FETs is clamped to the negative operating voltage potential (VSS) via an n-channel clamp FET (Q5),
- that the three pairs of complementary switch FETs (Q1, Q2, Q4) are switched in synchronism,
- and in that the two clamp FETs (Q3, Q5) are switched in time synchronism with the three pairs of complementary switch FETs (Q1, Q2, Q4) into a switching state opposite to the switching state thereof.

4. A switch means according to any one of claims 1 to 3,
characterized in that a protection circuit, in particular a diode protection circuit, is connected upstream of the input (IN1) of the switch means.

5. A switch means according to claim 2 or 4 when dependent on claim 2,
characterized in that two control signal sources for complementary control signals (C1, C̅1̅) are provided, and in that the control electrodes of the two switch FETs (Q1N, Q2N) and of the clamp FET (Q3P) of one signal path are connected to one control signal source (C1) and the, control electrodes of the second switch FET (Q1P, Q2P) and of the clamp FET (Q3N) of the other signal path are connected to the other control signal source (C̅1̅).

6. A switch means according to claim 3 or 4 when dependent on claim 3,
characterized in that two signal sources for complementary control signals (C1, C̅1̅) are provided,
and in that the control electrodes of the n-channel switch FETs and of the p-channel clamp FET (Q3) are connected to one control signal source (C1) and the control electrodes of the p-channel switch FETs and of the n-channel clamp FET (Q5) are connected to the other control signal source (C̅1̅).

7. A switch means according to at least one of claims 1 to 6,
characterized in that all FETs are constituted by MOS FETs.

8. A multiplexer having a plurality of channels (1...n) with a controlled switch means in each channel and with an output node (S) common to all channels (1...n),
characterized in that the channels (1...n) each have a switch means according to at least one of claims 1 to 7.

9. A multiplexer according to claim 8,
characterized in that an analog-to-digital converter is connected to the common output node (S).

## Revendications

1. Dispositif de commutation intégré comprenant,
une entrée (EIN1) et une sortie (AUS1),
une borne d'alimentation positive pour recevoir une tension d'alimentation positive (VDD) et une borne d'alimentation négative pour recevoir une tension d'alimentation négative (VSS),
un premier interrupteur commandé sous la forme d'un premier transistor de commutation à effet de champ à canal N (Q1N) qui est entièrement bloqué seulement dans une plage prédéterminée de tensions (VSS) et qui transmet un signal d'entrée présent sur l'entrée (EIN1) en recevant un signal de commande (C1),
un deuxième interrupteur commandé sous la forme d'un deuxième transistor de commutation à effet de champ à canal N (Q2N) disposé en série avec le premier transistor de commutation à canal N (Q1N) entre le premier transistor de commutation à canal N (Q1N) et la sortie (AUS1) du dispositif de commutation, qui est commandé en synchronisme avec le premier transistor de commutation à canal N (Q1N),
un transistor de blocage à effet de champ à canal P (Q3P ; Q3) qui, en configuration passante, force un point de connexion commun (N6, N2) entre le premier transistor de commutation à canal N (Q1N) et le deuxième transistor de commutation à canal N (Q2N) à une tension constante et qui est commuté partiellement en synchronisme avec le premier transistor de commutation à canal N (Q1N) et avec le deuxième transistor de commutation à canal N (Q2N), dans une configuration de commutation opposée à celle du premier transistor de commutation à canal N (Q1N) et du deuxième transistor de commutation à canal N (Q2N),
les deux transistors de commutation à canal N (Q1N, Q2N) étant formés dans un substrat de type P qui est relié à la borne d'alimentation recevant la tension d'alimentation négative (VSS),
et l'électrode de grille de chacun des trois transistors à effet de champ (Q1N, Q2N, Q3N) étant commandée par des signaux de même polarité, caractérisé en ce que,
le blocage par le transistor de blocage à canal P (Q3P) s'effectue sur la tension d'alimentation positive (VDD).

2. Dispositif de commutation selon la revendication 1, caractérisé en ce que,
il est prévu deux voies de signal perallèles entre l'entrée (EIN1) et la sortie (AUS1),
une première voie de signal comprend les deux transistors de commutation à canal N (Q1N, Q2N) et le transistor de blocage à canal P (Q3P) reliés à leur point de connexion commun (N6),
la deuxième voie de signal comprend une paire de transistors de commutation à effet de champ à canal P (Q1P, Q2P) disposés en série, leur point de connexion commun (N5) étant forcé à la tension d'alimentation négative (VSS) par un transistor de blocage à effet de champ à canal N (Q3N), lorsque ce dernier est passant,
les deux transistors de commutation à canal P (Q1P, Q2P) sont formés dans un substrat de type N qui est relié à la borne recevant la tension d'alimentation positive (VDD),
le premier transistor de commutation à canal P (Q1P) relié à l'entrée (EIN1) est entièrement bloqué seulement dans une plage prédéterminée de tensions d'entrée (VDD, VSS) et transmet un signal d'entrée lorsqu'il reçoit un signal de commande (C1, C̅1̅),
et le transistor de blocage à canal N (Q3N) est commuté partiellement en synchronisme avec les deux transistors de commutation à canal P (Q1P, Q2P), dans une configuration de commutation opposée à celle de chacun des deux transistors à canal P (Q1P, Q2P).

3. Dispositif de commutation selon la revendication 1, caractérisé en ce que,
trois paires de transistors de commutation à effet de champ complémentaires (Q1, Q2, Q4), comprenant chacune un transistor de commutation à effet de champ à canal N et un transistor de commutation à effet de champ à canal P en parallèle, les trois paires étant disposées en série entre l'entrée (EIN1) et la sortie (AUS1),
les premier et deuxième transistors de commutation à canal N sont les transistors de commutation complémentaires à canal N des première et deuxième paires (Q1, Q2),
les transistors de commutation à canal N sont formés dans un substrat de type P qui est relié à la borne d'alimentation recevant la tension d'alimentation négative (VSS), et les transistors de commutation à canal P sont formés dans un substrat de type N qui est relié à la borne d'alimentation recevant la tension d'alimentation positive (VDD),
et la première paire (Q1) de transistors de commutation complémentaires est entièrement bloquée seulement dans une plage prédéterminée de tensions d'entrée (VDD, VSS) et transmet un signal d'entrée en recevant le signal de commande (C1, C̅1̅),
un point de connexion commun (N2) entre les première (Q1) et deuxième (Q2) paires de transistors de commutation complémentaires est forcé à la tension d'alimentation positive (VDD) par le transistor de blocage à canal P (Q3) dans sa configuration passante, et un point de connexion commun (N3) entre les deuxième (Q2) et troisième (Q4) paires de transistors de commutation complémentaires est forcé à la tension d'alimentation négative (VSS) par un transistor de blocage à effet de champ à canal N (Q5),
les trois paires de transistors de commutation complémentaires (Q1, Q2, Q4) sont commutées en synchronisme,
et les deux transistors de blocage (Q3, Q5) sont commutés partiellement en synchronisme avec les trois paires de transistors de commutation complémentaires (Q1, Q2, Q4) dans une configuration de commutation opposée à celle de ces paires.

4. Dispositif de commutation selon l'une quelconque des revendications 1 à 3, caractérisé en ce que l'entrée (EIN1) du dispositif de commutation est munie d'un circuit de protection, en particulier un circuit de protection à diodes (D1, D2).

5. Dispositif de commutation selon la revendication 2 ou la revendication 4 lorsqu'elle se refère à la revendication 2, caractérisé en ce qu'il est prévu deux sources de signal de commande pour fournir des signaux de commande complémentaires (C1, C̅1̅) et en ce que les électrodes de commande des deux transistors de commutation (Q1N, Q2N) et du transistor de blocage (Q3P) de l'une des voies de signal sont reliées à l'une des sources de signal de commande (C1) et les électrodes de commande des deuxièmes transistors de commutation (Q1P, Q2P) et du transistor de blocage (Q3N) de l'autre voie de signal sont reliées à l'autre source de signal de commande (C̅1̅).

6. Dispositif de commutation selon la revendication 3 ou selon la revendication 4 lorsqu'elle se réfère à la revendication 3, caractérisé en ce qu'il est prévu deux sources de signal de commande complémentaires (C1, C̅1̅)
et en ce que les électrodes de commande des transistors de commutation à canal N et du transistor de blocage à canal P (Q3) sont reliées à l'une des sources de signal de commande (C1) et les électrodes de commande des transistors de commutation à canal P et du transistor de blocage à canal N (Q5) sont reliées à l'autre source de signal de commande (C̅1̅).

7. Dispositif de commutation selon au moins une des revendications 1 à 6, caractérisé en ce que tous les transistors à effet de champ sont des transistors MOS.

8. Multiplexeur à plusieurs canaux (1...n) comprenant un dispositif commandé de commutation associé à chaque canal et un noeud de sortie (S) commun à tous les canaux (1...n), caractérisé en ce que les canaux (1...n) comprennent chacun un dispositif de commutation selon au moins une des revendications 1 à 7.

9. Multiplexeur selon la revendication 8, caractérisé en ce que le noeud de sortie commun (S) est relié à un convertisseur analogique/numérique.
